# EUROPÄISCHE PATENTANMELDUNG

(11) **EP 1 359 443 A1**
(43) Veröffentlichungstag der Anmeldung: **05.11.2003**
(21) Anmeldenummer: 01982054.7
(22) Anmeldetag: 16.07.2001
(51) Int. Cl.: G02B 6/26

(54) **OPTISCHES KOPPELSYSTEM**

(30) Priorität: 10.01.2001 US 758876
(71) Anmelder: Wang, Zhijiang, Jia Ding Town, Jia Ding County, Shanghai 201800 (CN); Yu, Qinyue, Jia Ding Town, Jia Ding County, Shanghai 201800 (CN); Wang, Ying, Jia Ding Town, Jia Ding County, Shanghai 201800 (CN)
(72) Erfinder: Wang, Zhijiang, Jia Ding Town, Jia Ding County, Shanghai 201800 (CN); Yu, Qinyue, Jia Ding Town, Jia Ding County, Shanghai 201800 (CN); Wang, Ying, Jia Ding Town, Jia Ding County, Shanghai 201800 (CN)
(74) Vertreter: Körner, Peter
(86) Internationale Anmeldenummer: CN0101174
(87) Internationale Veröffentlichungsnummer: WO02056074

(57) **Zusammenfassung**

Ein optisches Kopplungssystem gibt optische Kopplungsmethode und Einrichtung der hocheffektiven Laserlichtbündelkopplung, besonders die neue Baustruktur des Umformens und des neuen Ausrichtens des Lichtbündels der Halbleiterlaserarray bekannt. Infolge der Benutzung der speziellen Methode, die gepumpten Laserlichtstrahle in optische Fasern oder andere Medien einzukoppeln, kann man Hocheffektivität erreichen. Diese Entdeckung kann hocheffektive Hochleistungsfaserlaser, optische Verstärker und andere Festkörperlaser realisieren. Diese Lichtbündelumformenbaustruktur kann beträchtlich die Lichtbündelqualität der Halbleiterlaserarray verbessern, leicht durchführen, einrichten und justieren. Ein mit Halbleiterlaserlicht gepumptes Festkörperlaser dieser Entdeckung enthält einschließlich Lasermedium, Fokussierungselement, Lichtquelle; Lichtquelle enthält mindestens eine Halbleiterlaserarray, Lichtbündelablenker, Abbildungsoptiksystem und Lichtbündelrediktionator.

## Beschreibung

### Technischer Bereich

Diese Entdeckung stellt ein optisches System dar, in dem es Halbleiterlaser und optische Faserkopplung enthält, besonders über Halbleiterlaserlichtumformen, Realisierung der hocheffektiven Hochleistungsfestkörperlaser und des optischen Faserlasers und optischer Faserverstärker sowie das mit Hocheffektivität durch optische Fasern transportierte Halbleiterlaserlicht.

### Stand der Technik

In der letzten Zeit ist es gelungen, mit Halbleiterlaserlicht optische Faserlaser zu pumpen, viele physikalische Ursachen nützen dieser Entwicklung. Halbleiterlaserlicht liefert eine Lichtpumpe mit Hochleistungsdichte, so optische Faserlaser und optischer Faserverstärker haben dann Hocheffektivität, Lichtbündels gehen bei Lichtpumping durch die Umhülle in den Kern und erregen Lasermedium auf, Laservorgang beschränkt sich nur im Kern, so wird Halbleiterlaserlicht mit niedriger Helligkeit zu einem sehr dünnen optischen Faserlicht umgewandelt, die Helligkeit steigt über das tausendfache, mit noch effektiver Methode wird es noch höhere Helligkeit erreichen, oder noch leistungsvoller werden Laserlichtbündels durch optische Faser transportiert. Nehme optischen Faserlaser als Beispiel, optischer Faserlaser ist gegenwärtig im allgemein eine einige zehnmeterige optische Faser mit zweischichtigen Umhülle, Kern ist eine sehr dünne dortierte singelmodige optische Quarzfaser, die sich im Zentrum der inneren Umhülle befindet, die äußere Umhülle mit niedriger Brechungindex ist aus Fulorplastik gebaut, so kann die Innenhülle bei Lichtpumping Lichtbündels von NA0.45 erhalten, Halbleiterpumplicht läuft durch farbänderliches Spiegel (Hochdurchlässigkeit für Pumplicht, Hochreflektionskoeffizient für Laserlicht) und tritt in die optische Faser, wenn Pumplicht noch kompakter ist, wird mehr Pumplicht in optische Faser eingeführt, so wird man mit Benutzung noch dünnerer Umhülle und viel kürzerer optischer Faser möglich sein und die Effektivität des optischen Faserlasers und des optischen Faserverstärkers steigern.

Allgemeine Halbleiterlaserarray (LDA) hat sehr langen lichtemitierten Bereich (1cmx1um), der aus mehreren lichtemitierten Einheiten, welche gegeneinander einen Zwischenabstand haben, besteht z. B. etwa 20 Einheiten, jede Einheit hat eine Breite 200um, in jeder Einheit werden wieder mehrere kleine Punkte mit einer Breite von 3-6um aufgeteilt, jeder Punkt emitiert 30-60mw. Diese lange Linierichtung heißt langsame Achsrichtung, Divergenzwinkel beträgt 10-15, die dazu senkrechte Richtung heißt schnelle Achserichtung, die Breite des lichtemitierten Bereich ist 1um, Divergenzwinkel ist 30-40, einige geometrischen Abmessungen der typischen LDA können Ausgangsleistung 20w, oder noch höhere Ausgangsleistung liefern, Halbleiterlaserarray kann 500-1400w Ausgangsleistung liefern,
infolge der sehr dünnen und langen geometrischen Abmessung der LDA ist die Einführung der Hochleistung (z.B.4000w) in die Hülle der optischen Faser ( z.B.200umx500um, NA0.45 ) eine Herausförderung.

Um immer mehr Lichtleistung in die optische Faser einzuführen, hat man sich viel Mühe gegeben, viele Patente beschäftigen sich im Bereich der Fokussierung der Halbleiterlaserlichtbündel, z. B. USP 5887096, 5825551, 5808323, 5805748, 5513201, und PCT WO 99/35724, PCT 97/14073 und USP 5802092, 5793783, 5790310, 5594752, 5579422, 5568577, 5333077, 5185758,5139609 und 4428647.

In USP 5887096 benutzt man Reflektionslinsensystem, um die Halbleiterlaserlichtbündels umzuformen und weiter zu führen. In USP 5825551, 5808323, 5805748 sind verschiedene Umformmethoden bekannt gegeben, Lichtbündel wird in der langen Richtung in viele Abschnitte unterteilt, und diese Abschnitte werden zu einem kreisformähnlichen Schnitt als Lichtpumpe neu ausgerichtet, in diesen Patente ist die Neuausrichtung bei Benutzung von zwei parallel stehenden ebenen Reflektionsspiegeln, oder bei Benutzung von mehreren kleinen Reflektionsspiegeln, oder bei Benutzung von mehreren Brechungsplatten realisiert. In PCT WO 97/14073 haben Hollmann und seine Mitarbeiter Halbleiterlaserlichtbündel, welche mehr als zwei sind, kollimatiert und kombiniert, aber solche Systeme sind schwierig einzurichten, zu justieren und durchzuführen. In USP 6151168 und früher veröffentlichen Artikeln (SPIE Vol. 3008,202,1997) gibt Goring ein optisches System bekannt, das bei Benutzung der schief stehenden Zylinderlinse und des schief brechenden Elements die Halbleiterlaserlichtbündel mit Hochleistung symmetrisiert, Nachteil dieses Systems ist: Lichtbündel werden nach dem ersten schiefbrechenden Element nicht kollimatiert, die Bildqualität solcher Lichtbündel muss man bei Benutzung einer Zylinderlinsenarray korrigieren, um ein gutes Ergebnis zu erhalten, oder man benutzt Glimmergitter, die Ursache ist: das schiefbrechende Element, welches nach der schief stehenden Zylinderlinse stellt, hat in der langsamen Achserichtung keine Kollimationsfähigkeit, deswegen wenn ebene Spiegelarray als zweites schiefbrechendes Element benutzt wird, kann der Divergenzwinkel in der langsamer Achsrichtung nur durch Zylinderlinsenarray korrigiert werden, solche Array ist sehr schwierig herzustellen, wenn keine Zylinderlinsenarray benutzt wird, wird Divergenzwinkel in der langsamen Achsrichtung durch Benutzung des Glimmergitters korrigiert, ein anderer Nachteil eines solchen Systems ist nicht möglich nach der Krümmung (Smile) von LDA passend zu korrigieren, die Krümmung von LDA wird all bekannt auf der Fläche des Rediktionators Kreuzungen entstehen und lässt Effektivität senken, kurz gesagt ist es schwierig, die vergangene Technik durchzuführen, außerdem ist es auch sehr teuer.

### Entdeckungsziel

Die von dieser Entdeckung gelieferte Methode und Einrichtung richteten Lichtbündel der Halbleiterlaserarray oder der zweidimensionalen Array neu aus und kombinieren dann solche Lichtbündel und lassen diese mit Hocheffektivität und Hochleistung in dem Gegenstand eintreten, z. B. optische Fasern. So wird man Hocheffektivität und Hochleistung von Festkörperlasern, optischen Lasern, optischen Faserverstärkern und Halbleiterlaserlicht, das mit Hocheffektivität durch optische Faser transportiert.

Diese Entdeckung liefert eine neue Methode der Neuausrichtung der Halbleiterlichtbündel und lässt diese Lichtbündel zu einer Kreisform annähern.

### Überblick der Entdeckung

Um das obige Ziel und andere Ziele zu erreichen, nach der Beschreibung dieser Entdeckung, die Einrichtung dieser Entdekkung besteht aus folgenden Teilen: mindesten eine Halbleiterlaserarray, Lichtbündelablenker, Lichtbündelrediktionator, optisches System, das sich zwischen dem beschriebenen Lichtbündleablenker und dem Rediktionator befindet, dieser Lichtbündelanlenker kollimatiert die von der Halbleiterlaserarray emitierten Lichtbündel in der schnellen Achsrichtung und lenkt Lichtbündel längs der Achserichtung gegenseitig ab; das beschriebene optische System kollimatiert die schon abgelenkten Lichtbündel in der langsamen Achsrichtung und lässt jedes Lichtbündel in den Rediktionator eintreten, so werden Lichtbündels nach Durchlauf vom Rediktionator in einer Richtung oder in mehreren vorher festgelegten Richtungen sich breiten.

Optischer Faserlaser dieser Entdeckung besteht aus folgenden Teilen:
Mindestens eine Halbleiterlaserarray, eine optische Faser mit Innenumhülle; ein Lichtbündelablenker; ein Lichtbündelrediktionator; ein optisches System, das sich zwischen dem beschriebenen Lichtbündelablenker und dem Rrediktionator befindet, ein Fokusierungselement koppelt die von der Halbleiterlaserarray stammenden Lichtbündels in die beschriebene Umhülle ein.

Die anderen Ziele , Fortschritte und Realisierbarkeit dieser Entdeckung werden durch folgende Beschreibung mehr und mehr klar sein, aber die Beschreibung und Beispiele dieser Entdekkung erläutern nur Problem. Jeder, der die allgemeine Technik beherrscht, kann Inhalt und Methode dieser Entdeckung verschiedene Änderungen machen und verbessern.

### Erläuterung der Figuren

Fig.1 zeigt einige mögliche Ergebnisse des Lichtbündelumformens und des Lichtbündelausrichtens von LDA, hier CSA ist eine typische Zeichnung der lichtemitierten Einheit von LDA, in Fig. ist nur eine Zeichnung eines einzigen Lichtbündels als Repräsentant ausgezeichnet.
Fig.2 zeigt das allgemeine Grundprizip dieser Entdekkung für Lichtbündelumformen.
Fig.3(a) und 3(b) zeigen ein Beispiel dieser Entdekkung, und zwei seitliche Sichtbilder von LDA, hier ist FAC so gestellt, damit Zylinderflächenachse mit der lichtemitierten Linie einen kleinen Winkel bildet, Lichtbündelrediktionator ist ein Satz von ebenen Spiegels.
Fig.3(c) und 3(d) sind zum Vergleich benutzt, im allgemein Fall ist Zylinderachse von FAC parallel zu der lichtemitierten Linie,in diesem Fall entsteht keine Lichtbündelablenkung.
Fig.3(e) zeigt die relative Beziehung zwischen FAC und der lichtemitierten Linie von LDA.
Fig.4(a) und 4(4b) zeigt das Prinzip der zwei Type der Lichtbündelrediktionators, hier in Fig.4(a) ist Lichtbündelrediktionator ein Satz von ebenen Spiegels, in Fig.4(b) ist Lichtbündelrediktionator von einem Keilensatz.
Fig.5(a) zeigt ein Lichtbündelablenker, welcher Kollimationslinse CL und Ablenkungsprismen enthält;
Fig.5(b) zeigt die Beziehung zwischen der lichtemitierten Linie von LDA und PSM;
Fig.5(c) zeigt Lichtstrahlen nach drei Prisma von PSM.
Fig.6 zeigt Lichtbündelablenker, der aus einem Satz von ebenen Spiegeln MX besteht.
Fig.7(a) zeigt die Ablenkungswirkung, indem man anstelle MX in Fig.6 einen gedrehten und gleichzeitig auch gekrümmten Reflektionspiegel nimmt;
Fig.7(b) und Fig.7(c) sind zwei deformierte Formen von PSM der Fig.5, beide deformierten Formen haben eine ununterbrochene Oberfläche.
Fig.8(a) und 8(b) zeigen ein anderes Beispiel bei Benutzung des Feldspiegels.
Fig.9 zeigt ein anderes Beispiel dieser Entdeckung, indem bei Benutzung der Mikrolinsenarray MSL als Lichtbündelablenker; Fig.9(a) zeigt die relative Beziehung zwischen Linsen und der lichtemitierten Linie ;Fig.9(b), 9(c) sind zwei Sichtbilder dieses Beispiels.
Fig.10(a) und 10(b) zeigen Lichtbündelumformmethode dieser Entdeckung .Hier bildet optisches System AOS das abgelenkte Bild der lichtemitierten Einheiten auf dem Lichtbündelrediktionator BR ab, AOS lässt Hauptlichtlinien der lichtemitierten Einheiten in BR eintreten, und die Lichtbündel, die von BR austretenden sind, nach der neuen Ausrichtung in einer gleichen Richtung weiter breiten.
Fig.11 zeig auch allgemeines Prinzip dieser Entdekkung, indem Lichtbündel von LDA parallel verschiebend abgelenkt. Fig.11(a) zeigt das Aufteilen der Lichtbündels und die Lichtbündelformen vor und nach der Ablenkung.
Fig.12 zeigen einige Beispiele der optischen parallel verschiebend Ablenkungselemente. In Fig.12(a) wird ein optischer Plattensatz WG1 benutzt, die von der lichtemitierten Einheiten EM stammenden lichtbündels werden von FAC kollimatiert, dann von WG abgelenkt. Fig.12(b,c,d) zeigen die Ablenkungen, die durch drei ebene Platten entstehen.Fig.12(e) und 12(f) zeigen zwei Sichtbilder Ablenkung bei Benutzung vom Prismensätze; Fig.12(g) zeigt den Lichtstrahlverlauf in einem Prismas vom Prismensatz PSMG.
Fig.13 zeigt einige Beispiele der parallel verschiebend optischen Ablenkungselemente. Indem zeigen Fig.13(a) und 13(c) zwei Sichtbilder des parallel verschiebend Ablenkungssatzes, der aus Keilen mit den verschiedenen Dicken besteht;
Fig.13(b) und (d) zeigen die parallel verschiebend Ablenkungen, welche bei Benutzung der gleichen Keilen entstehen;
Fig.13(e) zeigt Lichtbündelaufteilung und Lichtbündelablenkungen, welche bei Benutzung des ebenen Spiegelsatzes entstehen;
Fig.13(f) zeigt das seitliche Sichtbild dieses ebenen Spiegelsatzes.
Fig.14 zeigt ein Beispiel, in dem man sphärisches Spiegel MR1 als AOS in Fig.10(a),(b) genutzt.
   Im Beispiel von Fig.15 kombiniert ein einziger sphärischer Spiegel die Wirkung von OS und BR.
Fig.16 zeigt einen sphärischen Spiegel MR1, der eine teilweise Wirkungsfunktion der Fokussierungseinrichtung hat.
Fig.17 zeigt einen sphärischen Spiegel, der gleichzeitig auch eine Fokussierungseinrichtung ist.
Fig.18 ist ein Beispiel eines optischen Faserlasers.
Fig.19 zeigt zwei Sätze des Reflektionsspiegels MMG als Lichtbündelrediktionator, und es entstehen zwei Gruppen von Ausgangslaserlichtbündeln.
Fig.20(a) und 20(b) sind zwei Sichtbilder des Lichtbündelumformens der zweidimensionalen Halbleitelaserarray.

### Inhalt dieser Entdeckung

In dieser Entdeckung sind Methode und Einrichtungen der hocheffektiven Kopplung der Laserlichtbündel, besonders Lichtbündelumformmethode und Neuausrichtenmethode der Halbleiterlaserarray (LDA) bekannt gegeben. Bei Benutzung dieser Methode werden Laserlichtbündel mit Hocheffektivität in optische Fasern und andere Medien eingeführt. Mit dieser Entdekkung können Festkörperlaser mit Hocheffektivität und Hochleistung realisiert werden.

Diese Lichtbündelumformbaustruktur kann die Qualität der Lichtbündel der Halbleiterlaserarray beträchtlich verbessern und ist leicht durchführbar und leicht justierbar. Deshalb mit der Bekanntgabe dieser Kopplungsbaustruktur können Halbleiterlaserlichtbündels effektiv in optische Faser eingeführt werden.

Mit diesem System kann man optische Faserlaser mit Hocheffektivität und Hochleistung, optische Faserverstärker oder Festköperlaser fertigen.

Methode und Einrichtung zur Benutzung des Lichbündelumformens und des Lichtbündelausrichtens teilen Lichtbündels von LDA in der langsamen Achserichtung in viele Teile auf, und lenken diese in der langsamen Achserichtung ab, kombinieren die schon aufgeteilten Teile nach der schnellen Achsrichtung, am Ende vergrößert Lagrange konstant in der schnellen Achsrichtung um n-Fache und verkleinert in der langsamen Achsrichtung um n- Fache.

Diese Entdeckung zeigt eine neue Ablenkungsmethode, welche bei Benutzung des Lichtbündelablenkers die Lichtbündel von LDA in der schnellen Achserichtung ablenkt. Deshalb enthält die Einrichtung dieser Entdeckung aus folgenden Teilen besteht: mindestens eine Halbleiterlaserarray (LDA); Lichtbündelablenker; Lichtbündelrediktionator; ein normales optisches System, das sich zwischen dem beschriebenen Lichtbündelablenker und dem beschriebenen Rediktionator befindet, der oben beschreibenden Lichtbündelablenker kollematiert die von den lichtemitierten Einheiten stammenden Lichtbündel grundsätzlich in der schnellen Achserichtung, lenkt gleichzeitig die Lichtbündels gegenseitig in der schnellen Achsrichtung mit verschiedenen Winkeln ab; das beschreibende normale optische System kollimatiert die Lichtbündeln in der langsamer Achsrichtung und lässt jeden Lichtbündel in den beschriebenen Lichtbündelrediktionator eintreten, nach dem beschriebenen Lichtbündelrediktionator werden Lichtbündel sich in einer oder eineigen vorher gewünschten Richtungen breiten. Lichtbündelablenker haben verschiedene Bauformen, z. B. die Achse der optischen Teile mit zylindrischer Fläche oder der stockförmigen optischen Teile bildet mit der lichtemitierten Linie von LDA einen vorher gewünschten Winkel. Das normale optische System besteht mindestens aus einer Linse oder einem Linsensatz oder den brechenden und reflektierenden Spiegel; das normale optische System soll sich in der Stellung befinden, damit die vom Lichtbündelablenker austretenden Lichtbündel in der langsamer Achsrichtung kollimatiert werden sollen und auf den Lichtbündelrediktionator eintreten. Das Ergebnis der Benutzung des beschriebenen normalen optischen Systems vermeidet die Notwendigkeit der Benutzung der komplizierten optischen Elemente wie z.B. Zylinderlinsenarray, solche optischen Teile sind schwierig herzustellen und sind praktisch nicht anwendbar, in der Einrichtung dieser Entdeckung kann ein Lichtbündeldiktionator verschiedene Formen, z.B. den ebenen Reflektionsspiegelsatz, den optischen Keilensatz, ein optisches Gitter oder andere Kombinationsformen haben.

Bei Benutzung der Lichtbündelumformmethode dieser Entdeckung, Lagrange Konstant der erhaltenen Lichtbündel steigt in der schnellen Achsrichtung um das n-Fache und verkleinert in der langsamen Achsrichtung um das n-Fache, deswegen soll die Lichtbündelumformeinrichtung folgende Teile enthalten: eine Halbleiterlaserarray (LDA), Lichtbündelablenker, Lichtbündelrediktionator, normales optisches System zwischen dem Lichtbündelablenker und dem Rediktionator. Der Lichtbündelablenker enthält hier eine zylinderförmige Kollimationslinse, die vor LDA steht und lässt die zylinderflächenachse mit der lichtemitierenden Linie von LDA einen vorher gewünschten Winkel bilden. Lichtbündelrediktionator (neu Ausrichtung) ist hier ein Ebenspiegelsatz, viele ebene Spiegel verschieben gegeneinander einen vorher festgelegten Winkel. Der beschriebene Lichtbündelablenker kollimatiert Lichtbündel in der schnellen Achserichtung, und lässt jedes austretende Lichtbündel in der schnellen Achserichtung gegeneinander mit einem vorher festgelegten Winkel verschieben. Das normale optische System kollimatiert die schon abgelenkten Lichtbündel in der langsamen Achsrichtung, und bildet gleichzeitig jedes lichtemitierende Element von LDA auf der vorher gewünschten Ebenspiegel des Ebenspiegelsatzes ab. So nach der Reflektion werden Lichtbündels sich in einer oder mehrer vorher festgelegten Richtungen verbreiten.

In dieser Einrichtung kann Lichtrediktionator (neue Ausrichtung) auch ein optischer Keilsatz sein. In diesem Fall richten viele optische Keilensätze in der schnellen Achserichtung aus, das beschriebene normale optische System kollimatiert die schon abgelenkten Lichtbündel in der langsamer Achsrichtung und bildet jedes lichtemitierende Element von LDA individuell auf dem vorher gewünschten optischen Keil des oben beschriebenen optischen Keilensatzes. So nach der Brechung werden Lichtbündels sich nach einer oder mehrer Richtungen verbreiten. Außerdem kann ein lichtdurchlässiges Gitter oder Reflektionsgitter als Lichtbündelrediktinator genutzt werden.

Deshalb soll eine Lichtbündelumformeinrichtung aus folgenden Teilen bestehen: ein LDA, ein Lichtbündelablenker, ein Lichtbündelrediktionator und ein zwischen dem Lichtbündelablenker und dem Lichtbündlerediktionator liegendes normales optisches System. In dem besteht Lichtbündelablenker aus einer mehr knotenförmigen Kollimationslinse, diese mehr knotenförmige Kollimationslinse befindet sich vor LDA und die Zylinderachse jedes einzelnen Knoten dieser mehr knotenförmigen Kollimationslinse mit der Achse des benachbarten Knotens verschiebt gegenseitig einen vorher festgelegten Abstand und ist parallel zu der lichtemitierenden Linie von LDA, verschiebende Richtung ist die schnelle Achsrichtung. Indem ist Lichtrediktionator (neue Ausrichtung) ein Satz von Reflektionspiegeln oder ein Satz von optischen Keilen oder optischen Gitter.
Der oben beschriebene Lichtbündelablenker lenkt die von LDA emitierten Lichtbündel je nach der Anforderung zur verschiedenen einzelnen Richtung ab. Um das Ablenkziel zu erreichen, kann man aber auch die Richtung aller Lichtbündel unveränderlich bleiben und jeden Lichtbündel zu dem anderen mit verschiedenem Abstand parallel verschieben. Mit vielen Methoden können die parallelen Verschiebungen der Lichtbündel durchgeführt werden. Z. B. Prismensatz, jedes Prisma verschiebt sich parallel zu dem benachbarten Prisma mit dem bestimmten Abstand; bei Benutzung des Reflektionspiegelsatzes, jeder Spiegel verschiebt sich parallel zu dem benachbarten Spiegel mit dem bestimmten Abstand ,Lichtbündels fallen schräg auf dem Spiegelsatz; oder bei Benutzung des anderen optischen Elementensatzes, welcher die Parallelverschiebung der Lichtbündels realisiert und die Richtung der Lichtbündels nicht ändert. So besteht eine Lichtbündelumformeinrichtung aus folgenden Teilen: mindestens eine LDA, Lichtbündelkollimator in der schnellen Achsrichtung, Lichtbündelablenker, der die schon kollimatierten Lichtbündel längs der schnellen Achsrichtung parallel ablenkt, Lichtbündelrediktionator, ein normales optisches System zwischen dem Lichtbündelablenker und dem Lichtrediktionator. Dieses optische System kollimatiert die vom Lichtbündelablenker austretenden Lichtbündel in der langsamen Achsrichtung und bildet jede lichtemitierte Einheit von LDA auf der vorher gewünschten Stellung des Lichtbündelrediktionators. Infolge Reflektion, Brechung, oder Beugung werden Lichtbündel in mindestens einer vorher festgelegten Richtung rediktioniert. Der beschriebene Schnellachsekollimator kann eine Zylinderlinse oder ein stockförmiges optisches Element sein, in der Einrichtung kann der Lichtbündelablenker ein Reflektionsspiegelsatz, Prismensatz oder optischer Keilensatz sein. Dieses optische System kann ein optisches brechendes Element, z. B. mindestens eine Linse oder ein Linsensatz; kann mindestens ein optisches reflektierendes Element, z.B. sphärische Reflektionsspiegel; kann auch ein optisches reflektierendes System sein, diese Lichtbündelrediktionator kann ein ebener Spiegelsatz, Keilensatz, Gitter oder andere Kombination sein.

Von der Beschreibung der obigen Einrichtung kann man eine Baustruktur eines Festköperlasers mit hocher Effektivität erhalten. Deshalb besteht ein mit einem effektiven Halbleiterlaserlicht gepumpter Festkörperlaser aus folgenden Teilen: ein aktiver Laserwerkstoff, z. B. Laserfaser, die innere Kerne mit aktivem Stoffe dortiert (gegenüber der äußere Hülle); oder Laserstock mit dortierten aktiven Stoffen (oder Platte); mindestens ein Fokussierungselement und eine Lichtquelle. Die Lichtquelle enthält mindestens eine LDA, Lichtbündelrediktionator, Lichtbündelablenker, ein normales optisches System, das sich zwischen dem Lichtbündelrediktionator und dem Lichtbündelablenker befindet. Beschriebenes optisches Fokussierunqselement führt die schon umgeformten Lichtbündel ins aktive Medium ein.

Von der Beschreibung der obigen Einrichtung können Lichtbündel von LDA mit Hilfe der Faserkopplungsweite sich breiten. So nach dieser Entdeckung bestehen Halbleitelaserarray und optisches Faserkopplungssystem aus folgenden Teilen: mindestens eine optische Faser, mindestens ein Fokussierungselement und eine Lichtquelle. Die Lichtquelle enthält mindestens eine Halbleiterlaserarray, Lichtbündelablenker, Lichtbündelrediktionator und normales optisches System zwischen dem Lichtbündelablenker und Lichtbündelrediktionator. Hier beschriebenes Fokussierungselement bringt die schon umgeformten Lichtbündels in die beschriebene optische Faser ein.

### Ausführungsbeispiele

### Lichtbündelumformen und Neuausrichten:

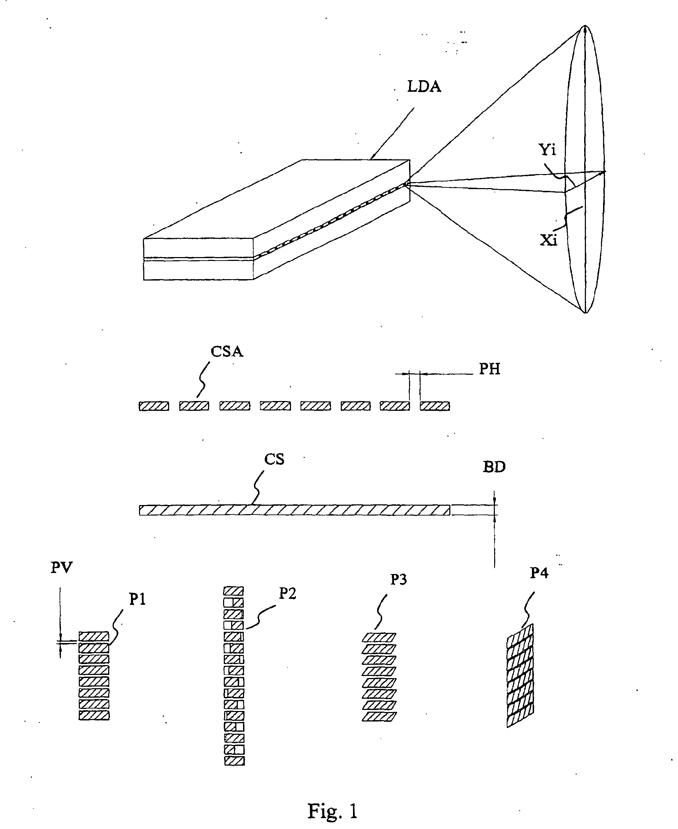

Die Baustruktur der lichtemitierten Einheit von LDA und die geometrische Struktur der Lichtbündels sind schon alle bekannt. Ein von LDA gepumpter Festkörperlaser ist im Allgemeinen auch normal. Infolge der schlechten Qualität der Lichtbündel wird die Effektivität in Wirkung gesetzt. Schlechte Lichtbündelqualität ist von der dünnen und langen Struktur des lichtstrahlenden Körpers ~1um×10mm verursacht. Außerdem hat der lichtstrahlende Kegel eine elliptische Schnittfläche, im Allgemeinen in der senkrechten Richtung, die schnelle Achse Xi heißt, zu der lichtstrahlenden Linie ist der Divergenzwinkel größer oder näherer 90,die Richtung, welche parallel zu der lichtstrahlenden Linie ist, heißt langsame Achse Yi, Divergenzwinkel etwa 10 (Fig.1), typische LDA hat 19 strahlende Einheiten, gegenseitiger Abstand dieser Einheiten ist 400um, LDA hat eine Lange 10mm in der langsamer Ächserichtung, 1um in der schnellen Achsrichtung. Von der obigen beschriebenen Theorie kann man wissen :Qualität des Lichtbündelumformens kann beträchtlich verbessert werden. Im Allgemeinen gesagt ist so genannte Lichtbündelumformung ist: Zerlegung und wieder Neuausrichtung der Lichtbündel, so wird die Lagrange Konstant in der langsamer Achserichtung verkleinert.
Fig.1 zeigt das Ergebnis nach dem Lichtbündelumformen und dem neuen Ausrichten der Lichtbündels von LDA, indem CSA ist eine typische lichtemitierte Linie von LDA, die Form P1 ist das Ergebnis der Zerlegung nach den Abständen zwischen zweier benachbarten lichtemitierten Einheiten und Neuausrichten in der schnellen Achserichtung; P3, P4 sind Ergebnisse der zwei anderen möglichen Neuausrichten. In drei Situationen P1, P2 und P3 ist P1 am besten.

Nach der oben beschriebenen Methode und Einrichtungen kann man das Ziel des Lichtbündelumformens und Neuausrichtens realisieren. Passende Einstellung der Position von LDA (Halbleiterlaserarray) und dem Lichtbündelablenker; durch Benutzung vom optischen System werden Lichtbündel in langsamer Achserichtung kollomatiert und die lichtemitierten Einheiten werden auf dem Lichtbündelrediktionator abgebildet; dann durch den Lichtbündelrediktionator werden Lichtbündels umgeformt und neu ausgerichtet. Lichtbündelablenker lässt die von LDA stammenden Lichtbündels in der schnellen Achserichtung gegenseitig verschiebt; Ablenkung kann verschiedene Austrittswinkeln sein , und kann auch verschiedene Verschiebungen sein. Der beste Lichtbündelablenker kollimatiert auch gleichzeitig die Lichtbündel in der schnellen Achserichtung ,das normale optische System kollimatiert die Lichtbündel in der langsamen Achsrichtung und lässt Lichtbündel auf den Rediktionator eintreten. In einem Beispiel, der Schnellachsekollimator und die lichtemitierten Linie von LDA sind gegenseitig schief justiert, so werden Lichtbündel in der schnellen Achsrichtung eine Verschiebungen entstehen. Durch Benutzung des normalen optischen Systems, z.B. Linse, Reflektionsspiegelsatz oder Reflektionsspiegel werden Lichtbündel in der langsamen Achserichtung kollimatiert und die lichtemitierten Einheiten von LDA werden auf dem Lichtbündelrediktionator abgebildet; diese Bilder richten grundsätzlich längs der schnellen Achserichtung aus, z. B. Fig.1, normales optisches System kann aus sphärischen oder asphärischen Flächen bestehen, aber z. B. Zylinderlinsearray oder andere Linsearray sind alle kein normales optisches System, Lichtbündel nach dem Rediktionator, welche schon abgelenkt sind, werden längs der schnellen Achsrichtung neu ausgerichtet, im idealen Fall, die endliche Lagrange Konstant im vergleich zu der ursprünglichen vergrössert in der schnellen Achsrichtung um n-Fach und verkleinert in der langsamer Achsrichtung um n-Fach. Obwohl die obige Zerlegung, Ablenkung und Neuausrichtung sind am besten nach der Anzahl der lichtemitierten Einheiten und dem Abstand zwischen zwei benachbarten Einheiten durchgeführt, um die höchste Helligkeit zu erreichen, aber im Allgemeinen kann man den lichtemiterten Körper zu CS in Fig.1 vereinfachen, in diesem Fall braucht man bei der Zerlegung der Lichtbündels nicht mehr zu berücksichtigen, wieviel lichtemitierte Körper LDA enthält, z. B. P2 in Fig. 1. Wenn LDA sehr viele lichtemitierte Körper enthält, ist diese Überlegung sehr nützlich. Am besten bei Zerlegung und Ablenkung hat man Ergebnisse der Formen P1 P2 P3 erhalten, aber in der folgenden Diskussion wird der Zwischenabständ PH der lichtemitierten Körpers nicht berücksichtigt. Die Anzahl der Lichtbündelzerlegungen ist nicht gleich der Anzahl des lichtemitierten Körpers von LDA, Endform können alle mögliche Formen von P1,P2 oder P3 sein. Im solchen Fall ist die Lichtbündelumformung leicht durchzuführen.

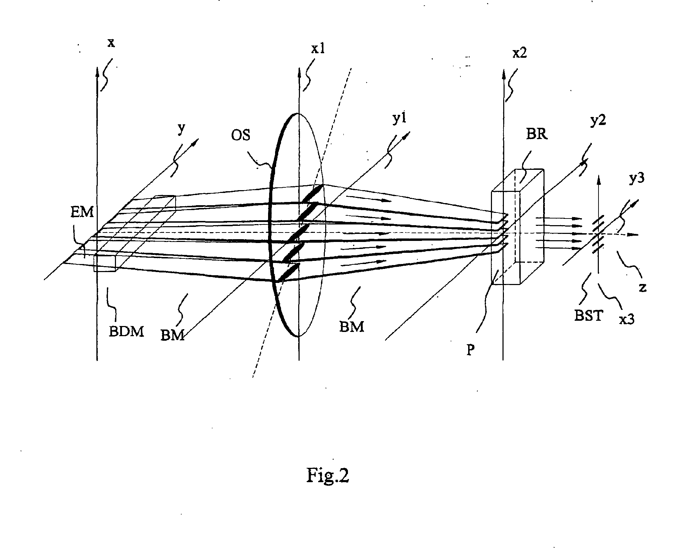

Fig.2 ist eine einfache Grundprinzipzeichnung dieser Entdekkung. Indem ist EM lichtemitierter Körper von LDA, um die Einfachheit in Fig2 sind nur fünf lichtemitierte Einheiten gezeichnet. BDM ist Lichtbündelablenker, welcher kollimatiert die von den lichtemitierten Einheiten austretenden Lichtbündels in der schnellen Achserichtung (x Achse) und lenkt Lichtbündel in der x-Achserichtung gegenseitig ab. Fig.2 zeigt eine Ablenkung des Austrittswinkels. Die Formen des Bündelflecks sind in verschiedenen Koordinatensystemen (x,y; x1, y1; x2,y2; x,y3) gezeigt. OS ist ein normales optisches System, das kollimatiert Lichtbündel in der langsamen Achserichtung (y Achse), und lässt schon abgelenkte Lichtbündels längs der x2-Achse auf den Lichtbündelrediktionator BR fallen, und nach der neuen Ausrichtung erhält man einen Lichtfleck P. Mit verschiedenen Einfallswinkeln fallen diese Lichtbündel in BR ein, nach dem Lichtbündelrediktinator werden alle Lichtbündel in eine Richtung geführt (man kann auch alle Lichtbündel in verschiedene vorher gewünschte Richtungen führen).Der Lichtbündelfleck BST hinter BR ist fast ganz wie P. So vergrößert Lagrange Konstant der endlichen Lichtbündel im Vergleich zu der ursprünglichen in der schnellen Achsrichtung um n-Fache und verkleinert n-Fache in der langsamen Achsrichtung. Optimierte Lichtbündel ( mit Lichtfleck P, z. B. P1, P2) können effektiv in die optische Faser oder andere Medien einfokussiert werden .Natürlich kann man solche optische Elemente kombinieren, z.B. kombiniert man OS und BR zu einem Element, so dieses einziges Element hat zwei Funktionen wie BDM und OS, es ist auch möglich, OS und BR zu einem Element zu kombinieren. Bei Benutzung der oben beschriebenen Struktur kann man gute Lichtbündelqualitat erreichen, ohne Zylinderlinsenarray zu benutzen, welche schwierig zu bearbeiten und sehr teuer sind. In OS soll die Anzahl der optischen Oberfläche möglich wenig sein, um den Verlust zu senken. Zum Beispiel besitzt ein normales optisches System nur einen sphärischen oder asphärischen Reflektionsspiegel, oder eine einzige Linse oder einen Linsensatz. Lichtbündelablenker BR ist ein Satz von ebenen Spiegeln oder ein Satz von optischen Keilen.

Unten wird eine Reihe von Beispielen der neuen Ausrichtung der Lichtbündel von LDA bekannt gegeben.

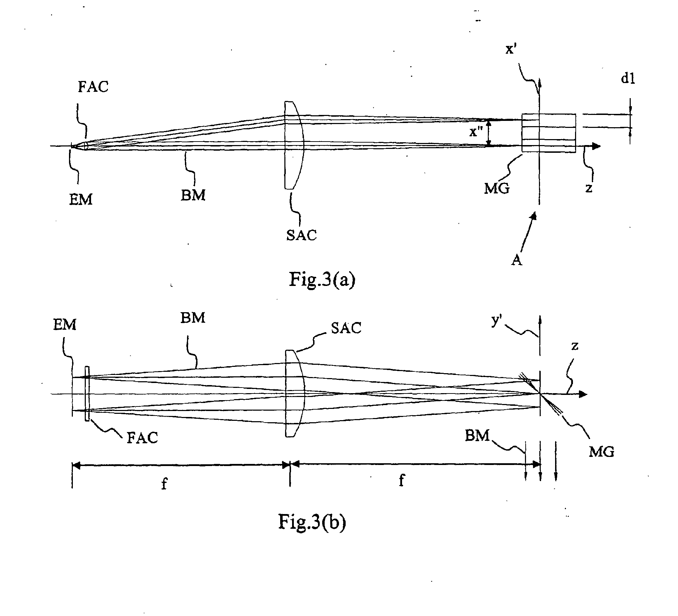

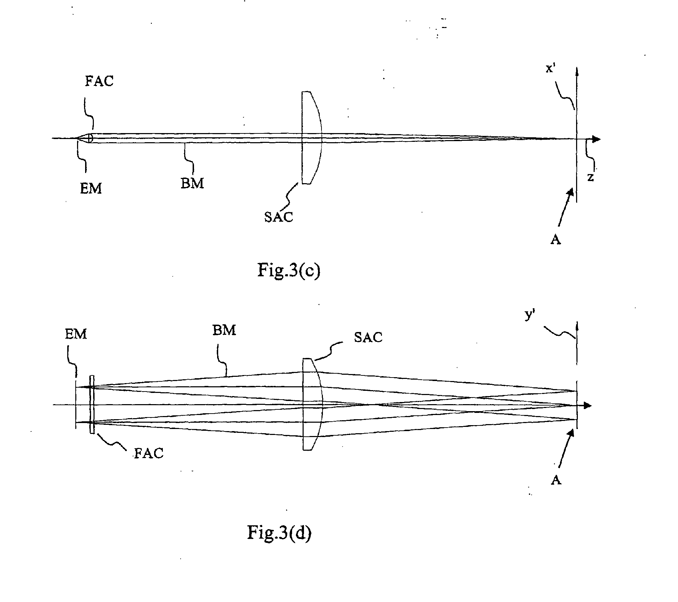

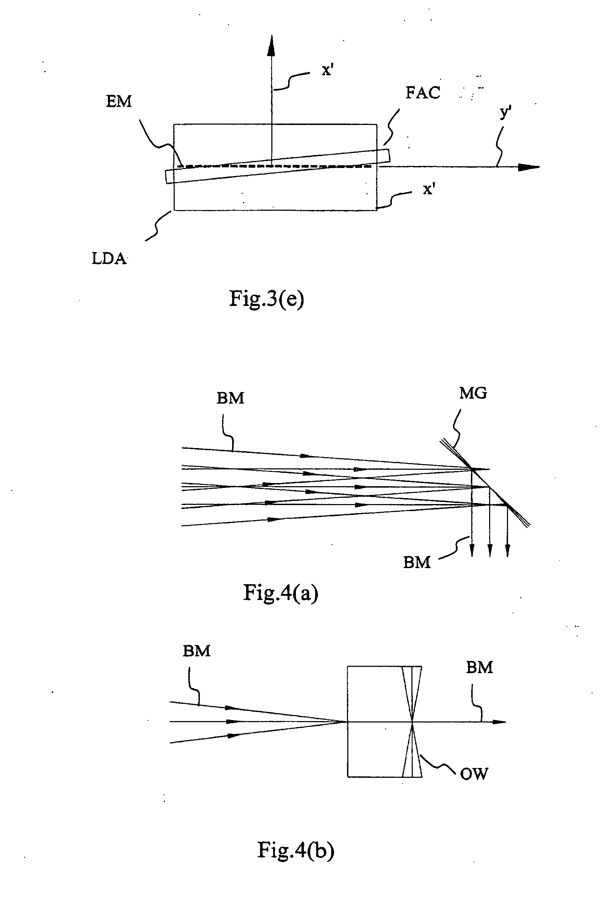

Fig.3(a) und 3(b) zeigen den Lichtverlauf eines Beispiels (von oben gesehen). In der Figur ist EM lichtlichtemitierter Körper von LDA. BM ist Lichtbündel. Abstand vom Objektiv SAC zu EM und Abstand vom SAC zu der Bildebene sind beide gleich Brennweite f. Der Schnellachsekollimator FAC kollimatiert die von EM ausstrahlenden Lichtbündels in der schnellen Achserichtung grundsätzlich, und SAC bildet diese Lichtbündel auf Bildebene ab. Wenn FAC und EM zueinander parallel stehen, (wie in Fig.3(c) und Fig.3(d) gezeigt), so der Lichtfleck auf der Bildebene mit gleicher Koordinate x', Dimension auf der y'-Achse ist auch dieselbe. Um Ablenkung zu realisieren, muss Zylinderflächeachselinse von FAC mit EM einen Winkel bilden (Fig.3(a), Fig.3(e)), in dieser Zeit ist FAC still innerhalb der yz-Koordinatenfläche, wenn die Koordinate y jedes Punktes von EM verschieden ist, Koordinate x ist auch verschieden (Fig.3(a)), so wird die Koordinate x" von EM auf der Bildebene eine vorher schon festgelegte Änderung entstehen. Hinter FAC sind Lichtbündel in der langsamer Achsrichtung noch nicht kollimatiert, eine Funktion von SAC ist, diese Lichtbündel in der langsamen Achserichtung zu kollimatieren (Fig.3(b))und fokussiert gleichzeitig die Hauptlinie (die zentrale Linie des Lichtbündels) jeder lichtemitierten Einheiten von EM auf der Ebene A, deshalb hat jeder kollimatierte Lichtbündel einen verschiedenen Einfallswinkel (Fig.3(b)). Um die Hochhelligkeit beim Lichtbündelumformen zu erhalten, ist die Langsamachsekollimation sehr wichtig.

In diesem Beispiel ist der Lichtbündelrediktionator (neu ausrichten) eine Satz von kleinen ebenen Spiegeln (oder kleinen Prismen, kleinen optischen Keilen), welcher auf der Bildebene A steht. Fig. 3(a) und Fig. 3(b) zeigen den Fall mit Benutzung des ebenen Spiegels, um deutlich zu sehen, sind nur drei ebene Reflektionsflächen gezeichnet. Mit verschiedener Höhe mit verschiedener Koordinale x) reflektieren kleine Spiegel die Lichtbündel mit verschiedenem Einfallswinkel nach einer Richtung (vorher festgelegter Richtung), dazu braucht man nur diese kleinen Spiegel gegeneinander mit einem kleinen vorher festgelegten Winkel zu stellen. Fig. 4(a) zeigt den Fall: Reflektionsspiegelgruppe MG rediktioniert drei Lichtbündel, welche schon kollimatiert sind; Fig. 4(b) zeigt die Benutzung von optischen Keilen OW (in Figur sind drei Keile gezeichnet) die Rediktionierung der Lichtbündel. Wenn man im Allgemeinen die Anzahl der lichtemitierten Einheiten nicht berücksichtigt, erhält man Lichtbündelfleck wie P2. Ganz klar kann man Totalreflektionsprismen als Reflektionspiegel benutzen. Die endliche Lagrange Konstant der Lichtbündels vergrößert im Vergleich zu der Lagrange Konstant der ursprünglichen von EM emitierten Lichtbündel, in der schnellen Achserichtung um n-Fache und verkleinert in der langsamer Achsrichtung um n-Fache, hier ist n die Anzahl der kleinen ebenen Spiegel (oder Prismas). Deshalb kann man die Größe der Lagrange Konstant der Lichtbündel in der x-und y-Richtung ungefähr gleich schaffen lassen. Es ist klar, kann auch anderer Rediktionator benutzt werden, welcher braucht nur alle Lichtbündel mit verschiedenem Einfallswinkel zu einer gleichen oder einer vorher festgelegten Richtung führen zu können.

Wenn die Anzahl der Reflektionsspiegel (Prismen/Keile) des Rediktionators gleich der Anzahl der lichtemitierten Einheiten von LDA ist, und gleichzeitig Winkel zwischen EM und FAC ist passend, so kann das Bild jeder lichtemitierten Einheit gerade auf dem kleinen Spiegel auffallen, so ist die endliche Bündelfleckform wie P1.In diesem Fall im Vergleich zu der Form P2 vergrößert die Lichtbündelhelligkeit um m-Fach, m ist der Umkehrwert des Verhältnisses von der Länge der lichtemitierten Einheit von LDA zu dem Abstand zwischen zwei benachbarten Einheiten.

In Fig. 3(a) ist die Breite des kleinen Spiegels in der Richtung x ungefähr gleich der Breite des Bildes von LDA. Die Bildvergrößerung ist gleich dem Verhältnis der Brennweite von SAC zu FAC. Wenn das Verhältnis von der Länge der lichtemitierten Einheit von LDA zu dem Abstand zwischen zwei benachbarten Einheiten klein ist, wird die Helligkeit absenken, obwohl Lichtbündel schon umgeformt sind. Wenn d1 sehr klein ist, wird das Bild einzelner lichtemitierten Einheit zwei oder noch mehr kleine Spiegel überdecken, weil die Normallinie jedes Spiegels verschiedene Richtung hat, wird der Divergenzwinkel vergrößert, und erleidet die Helligkeit auch eine Senkung. Die Aberration von FAC und SAC verursacht auch eine Vergrößerung des Divergenzwinkels und somit auch eine Senkung der Helligkeit. Um ein gutes Ergebnis zu erhalten, soll die Aberration möglich klein sein.

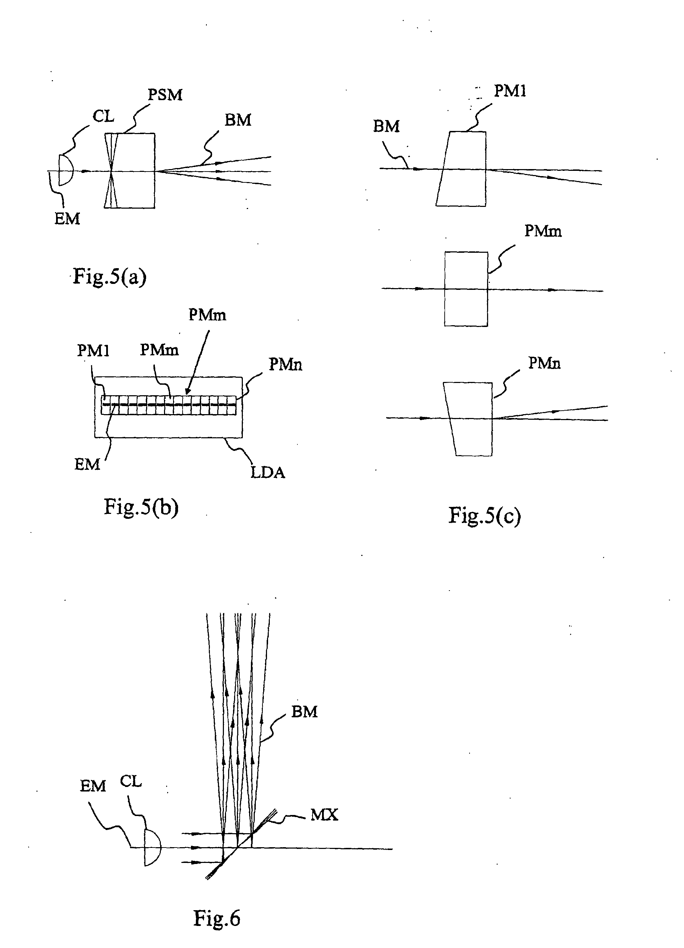

Im obigen Beispiel hat Lichtbündelablenker gleichzeitig zwei Funktionen, Lichtbündel in der schnellen Achserichtung zu kollimatieren und abzulenken. Natürlich kann man diese zwei Funktionen mit zwei Elemente realisieren, Fig. 5(a), 5(b), 5(c) sind Figuren solcher Beispiele, der Lichtbündelablenker dieses Beispiels enthält CL und PSM, CL ist Kollimationslinse, welche die von den lichtbündelemitierten Einheiten von LDA stammenden Lichtbündels in der schnellen Achserichtung kollimatiert; Prismensatz PSM besteht aus mehreren Prismen. Die relativen Stellungen von LDA und PSM sind in Fig. 5(b) gezeigt, Fig.5(c) zeigt, drei optische Wege der durch Prismen gehenden Lichbündel (Prismen PM1, PMm, PMn), Prismen mit verschiedenen Winkel lenken Lichtbündel nach vorher festgelegter Richtung, so wird Ablenkungsziel erreicht. Ein ähnliches Beispiel wie Fig.2, nach der Benutzung von OS und BR, die schon umgeformten Lichbündel mit Bündelfleck BST laufen alle grundsätzlich nach einer Richtung.

Im Beispiel von Fig.5 ist Ablenkung durch Brechung entsteht, und durch Reflektion kann man auch diese Ablenkung erreichen.Fig.6 zeigt: Lichtbündelablenker enthält CL und Ebenspiegelsatz MX, um deutlich zu sehen, sind nur drei gegenseitig verschobene Spiegel in der Figur gezeichnet. Lichtbündel laufen durch die Schnellachsekollimationslinse CL, dann werden Lichtbündels mit verschiedenem Austrittwinkel reflektiert, diese neuen Lichtbündel sind gegenseitig verschoben. Genau wie beim vorigen Beispiel, nach der Durchlauf von OS (oder SAC) und BR, laufen die schon umgeformten Lichtbündel mit Bündelfleck BST grundsätzlich nach einer Richtung.

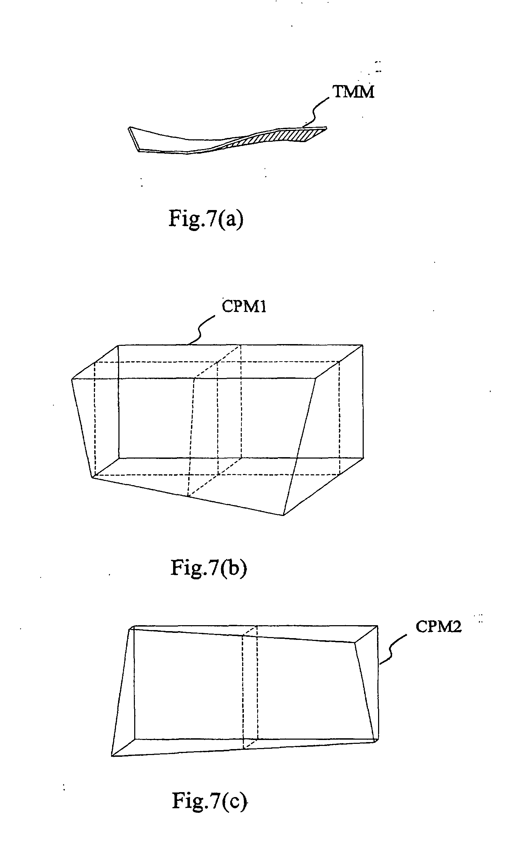

In Fig. 5 und Fig.6 gezeigten Beispiele sind mehrere einzelne Elemente als Lichtbündelablenker benutzt, ganz klar kann auch ununterbrochene Krümmungsfläche als Lichtbündelablenker benutzt werden. An Stelle von MX in Fig.6 ist TMM in Fig. 7(a) gesetzt, TMM ist ein umgedrehter und gekrümmmter Spiegel als Lichtbündelablenker. Fig. 7(b) und 7(c) sind zwei deformierte Prismen CPM1 und CPM2, welche an Stelle von PSM in Fig. 5 gesetzt sind. Es ist deutlich zu sehen, dass CPM1 und CPM2 die gleiche Schnittfläche wie kleine Prismen PM1, PMm und PMn haben, so hat PSM die gleiche Ablenkfunktion.

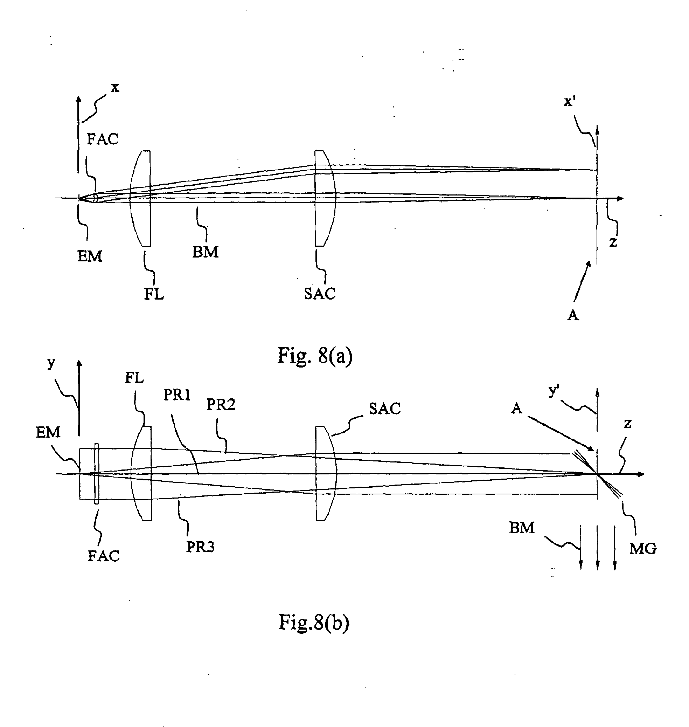

Fig.8(a) und 8(b) ist ein anderes Beispiel. In diesem Beispiel ist EM der lichtemitierte Körper von LDA; A ist Bildfläche; FL ist Objektiv ,Objektiv fokussiert Hautlichtstrahle (PR1, PR2, PR3) auf A (Fig. 8(a)); SAC ist Langsamachsekollimationslinse; Lichtbündel werden von FAC in der schnellen Achserichtung kollimatiert, nach Durchlauf von FL und SAC wird EM auf A abgebildet (Fig. 8(a)). Ganz gleich zum vorigen Beispiel, Achse von FAC mit EM bildet einen Winkel, so entsteht eine Ablenkung; auf der Bildebene steht Lichtbündelrediktionator, z. B. ebene Spiegelsatz; wenn Lichtbündel (und auch kollimatierte Lichtbündel) mit verschiedenen Winkeln in den Lichtbündelrediktionator eintreten, laufen diese Lichtbüdel dann grundsätzlich nach einer Richtung. Hier kann FL auch Zylinderlinse sein, die innerhalb der xz-Ebene keine optische Dioptrie haben kann, SAC kann auch eine Hyperbellinse sein, die innerhalb yz-Ebene und xz-Ebene verschiedene optische Dioptrien haben.

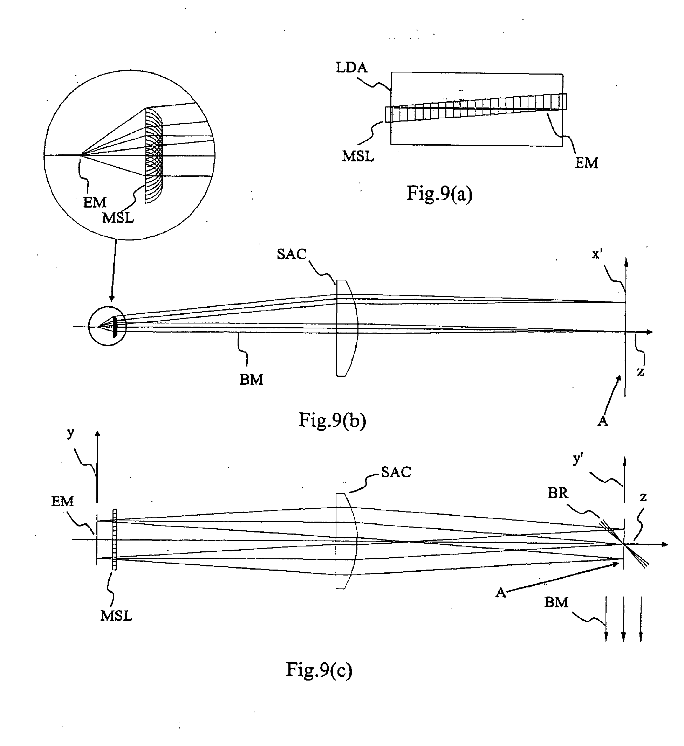

Fig. 9(b) und 9(c) zeigen zwei Sichtbilder eines anderen Beispiels. Der Unterschied zu dem Beispiel der Figur 3 ist hier Schiefstellung von FAC nicht genutzt, um Ablenkungen zu erreichen. Hier wird vielknotige Linse MSL benutzt, indem die Achse jedes Knotens ist parallel zu dem lichtemitierten Körper EM und verschiebt aber gegenseitig einen bestimmten vorher festgelegten Abstand, wie in Fig. 9(a) gezeigt. So werden Lichtbündel nach Durchlauf von MSL in der schnellen Achsrichtung gegenseitig einen Winkel abgelenkt, damit ist die Koordinate x' jedes Knotens auf der Bildebene A auch gegenseitig verschieden. Kollimatierte Lichtbündel jedes Knotens treten mit verschiedenen Winkeln auf dem Lichtbündelrediktionator BR auf der Bildebene ein. Nach der Durchlauf von BR werden Lichtbündel grundsätzlich nach einer Richtung. BR kann auch ein Satz von ebenen Spiegeln oder ein optischer Keilensatz sein.

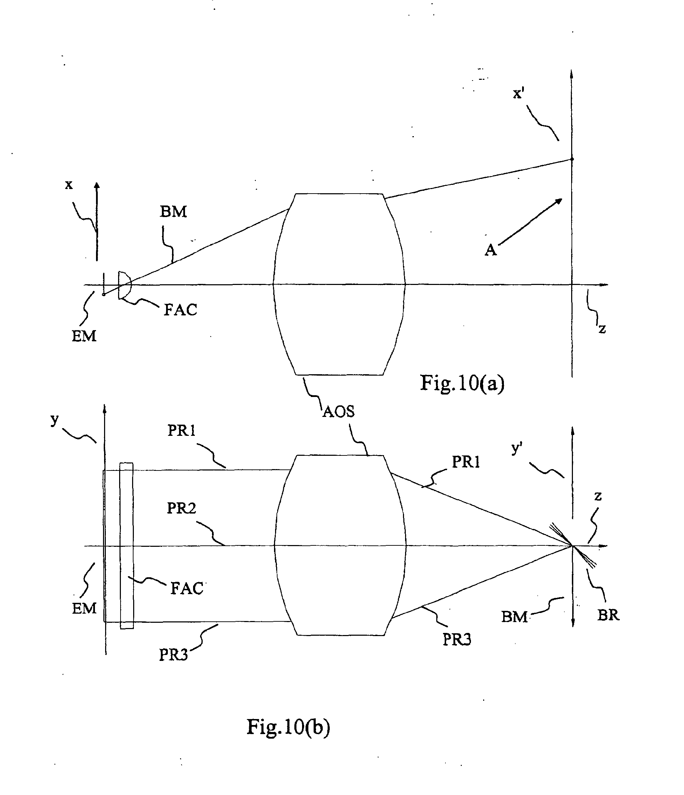

Im Allgmeinen nach dieser Entdeckung besteht Lichtbündelumformen aus folgenden Elementen: (a) Lichtbündelablenker, z. B. Zylinderlinsensatz, der schief zu der lichtemitierten Linie von LDA steht; (b) Rediktionator z. B. ebener Spiegelsatz, der sich auf der Bildebene befindet; (c) ein beliebiges normales optisches System AOS (z.B. brechendes optisches System, reflektierendes optisches System oder brechendes und reflektierendes System), das kollimatiert Lichtbündels in der langsamen Achserichtung und bildet das Bild der schon abgelenkten lichtemitierten Einheiten auf dem Lichtbündelrediktionator ab, und lässt auch die Hauptstrahllinie der lichtemitierten Einheiten von LDA ganz in den Lichtbündelrediktionator eintreten (wie in Fig. 10 gezeigt). Um alle schon rediktionierten Lichtbündel grundsätzlich in einer Richtung zu laufen, wenn Lichtbündel in der xz-Ebene nicht sehr gut kollimatiert sind (wie Fig. 10(a) gezeigt), am besten fordert man den Rediktionator schief zu den eintretenden Lichtbündeln zu stellen und diesen Schiefstellwert zu optimieren. Zum Beispiel bei Benutzung des ebenen Spiegelsatzes als Lichtbündelrediktionator, müssen ebene Spiegels nicht nur innerhalb der yz-Ebene sondern auch innerhalb xz-Ebene abgelenkt werden, um lichtbündel nach dem Durchlauf des ebenen Spiegelsatzes grundsätzlich nach einer Richtung zu laufen. Wie schon bekannt hat lichtemitierte Linie von LDA eine Krümmung (Smile), im bestimmten Krümmungsbereich kann diese Krümmung durch Reflektionsspiegel mit passender Ablenkung korrigiert werden, so kann man von LDA mit einer Krümmung immer noch Lichtbündel mit passender Lichtbündelqualität erhalten. Außerdem wenn die in den Lichtbündelrediktionator eintretenden Lichtbündel nicht gut genug kollimatiert werden, so muss Lichtbündelrediktionator aus mehreren sphärischen Spiegeln oder aus dem hyperbelförmigen Spiegelsatz bestehen. Deshalb das beste beliebige optische System AOS soll ein solches System sein, das die in den Lichtbündelrediktiontor eintretenden Lichtbündel gut genug kollimatiert, wie im vorigen Beispiel gezeigt, es ist leicht zu realisieren. In den vorliegenden Beispielen ist die Lichtbündelablenkung alle mit Austrittswinkelverschiebungen realisiert. Man kann auch mit parallelen Verschiebung und nicht Änderung der gründlichen Richtung der Austrittslichtbündel, einen anderen Typ der Lichtbündelablenker realisieren.

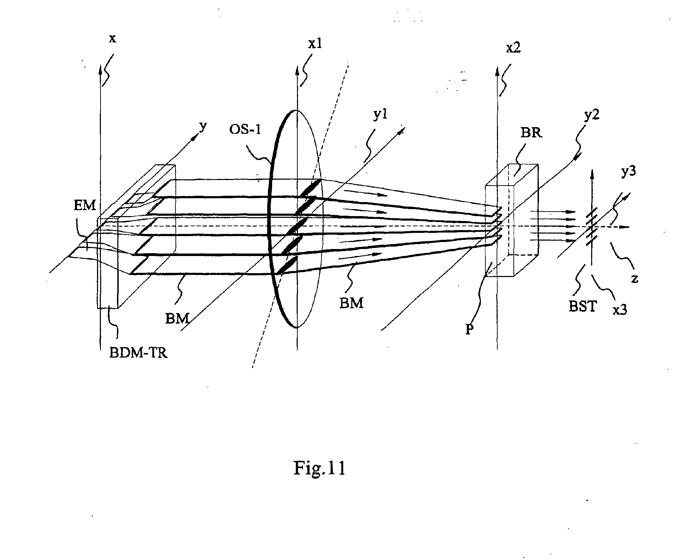

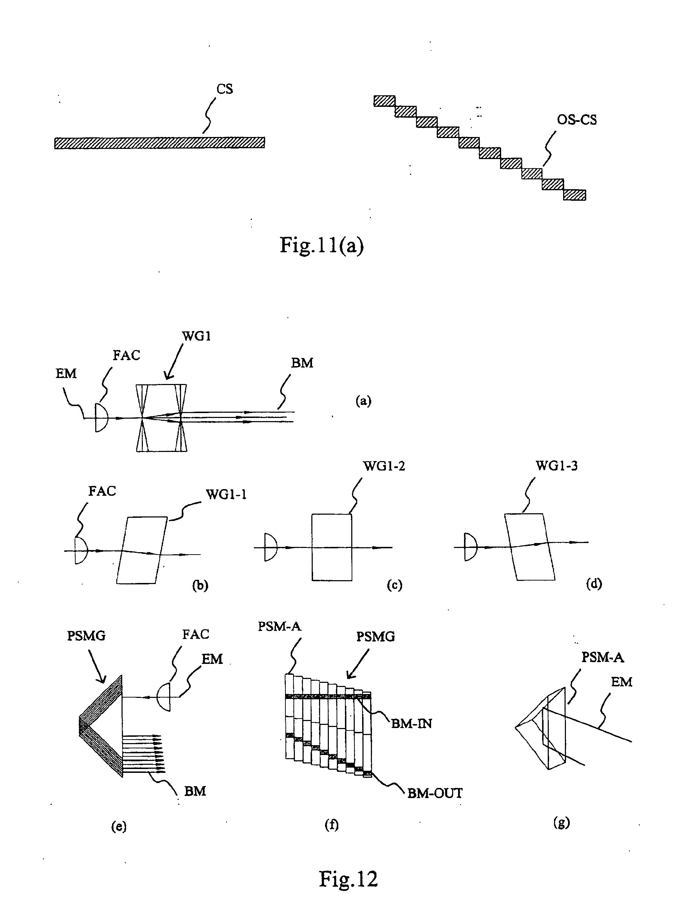

Fig. 11 ist eine einfache Zeichnung eines anderen Beispiels dieser Entdeckung, indem Lichtbündelablenker BDM-TR lässt Lichtbündel in der schnellen Achsrichtung eine parallel verschobene Ablenkung entstehen, EM ist lichtemitierter Körper von LDA, um einfach zu sehen, sind hier nur fünf lichtemitierte Einheiten gezeichnet. BDM-TR entsteht nicht nur eine Ablenkung und kollimatiert auch die von LDA stammenden Lichtbündels in der schnellen Achsrichtung (x-Achse). Infolge keiner Änderung der Austrittslichtbündel, nach der Durchlauf von BDM-TR ist die Hauptstrahllinie still parallel zu der z-Achse.

Figur 11 zeigt die Lichtbündelfleckform in den Koordinatensystemen (x, y; x1, y1; x2, y2; x3, y3 ), OS-1 ist ein beliebiges optisches System, das kollimatierte Lichtbündel in der langsamen Achserichtung (y-Richtung) und bildet die schon abgelenkten Lichtbündel auf dem Lichtbündelrediktionatorsystem BR ab. Diese Lichtbündel haben gegenseitig versciehdenen Einfallswinkel und richten längs der schnellen Achsrichtung aus, Lichtbündelfleckform ist wie P. Nach der Durchlauf des Lichtbündelrediktionators werden alle Lichtbündel grundsätzlich nach einer Richtung (oder nach einigen vorher festgelegten Richtungen) sich ausbreiten. Deshalb ist Bündelfleckform BST nach BR ungefähr gleich wie P. Deshalb vergrößert die endliche Lagrange Konstant in der schnellen Achsrichtung um das n-Fache und verkleinert in der langsamen Achsrichtung um das n-Fache, Lichtbündelfleckform (P-Form wie P1 oder P2) nach dem Optimieren lässt Lichtbündel leicht und effektiv in die optische Faser oder andere Medien eintreten. Sehr klar können alle Funktionselemente zu einem kombiniert werden. Z. B. bei Benutzung eines Elementes kann die Funktion von BDM-TR und OS-1 realisieren, oder man kann OS-1 und BR zu einem Element kombinieren. Um die Verluste zu vermindern, soll die Anzahl der optischen Fläche von OS-1 möglich wenig sein, z. B. Benutzung eines einzigen sphärischen (oder asphärischen) Flächenspiegels; Benutzung einer Linse oder eines Linsensatzes; Notfalls kann dieses optisches System auch Zylinderfläche enthalten.

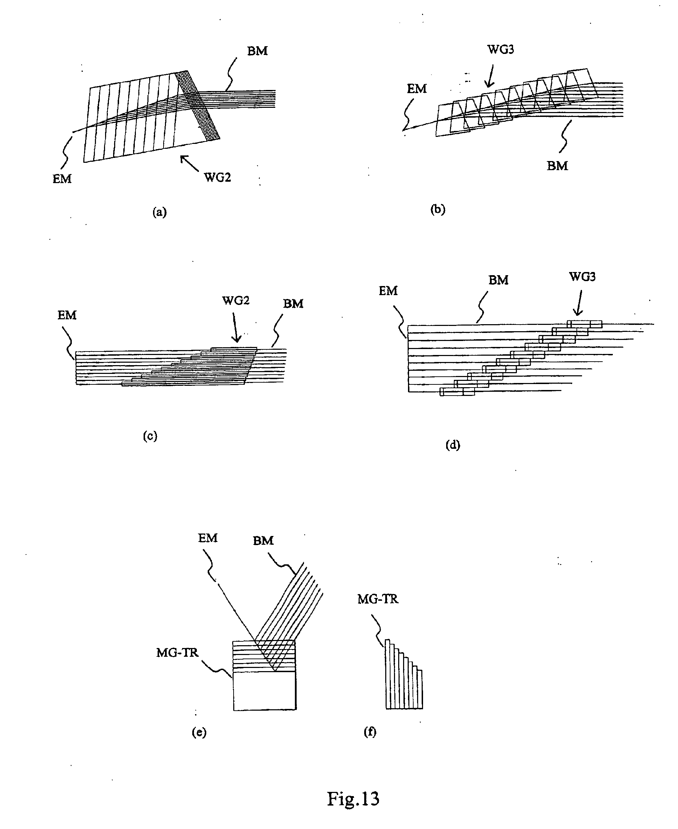

Viele verschiedene Methoden können Lichtbündel parallel ablenken und ändert Lichtbündelform von CS (Vernachlässigung des Abstand zwischen zwei lichtemitierten Einheiten) zu OS-CS, wie Fig. 11(a). Z. B. Fig. 12, Fig. 13. Zuerst sollen die von der Halbleiterlaserarray emitierten Lichtbündel in der schnellen Achsrichtung kollimatiert werden, und Lichtbündel werden dann zerlegt und parallel abgelenkt. Bei Benutzung von brechenden oder reflektierenden optischen Elementen, die gegeneinander verschoben sind, als Lichtbündelablenker, kann man parallele Ablenkung der Lichtbündels realisieren. Fig. 12(a) zeigt: die vom lichtemitierten Köper EM ausgehenden Lichtbündel werden von FAC in der schnellen Achsrichtung kollimatiert, werden danach durch eine Gruppe der optischen parallelen Platte WG1 abgelenkt. Um deutlich zu sehen, sind in Figur nur drei Platten gezeichnet. Fig. 12(b), (c), (d) zeigt die Entstehung der parallelen Verschiebungen durch diese drei ebenen Platten. Fig.12(e)(f) zeigt zwei Sichtbilder der parallel verschobenen Ablenkung, die bei Benutzung vom Prismensatz entsteht; Fig. 12(g) ist die Lichtstrahlverlauf innerhalb des einzelnen Prismas PSM-A. Die vom lichtemitierten Körper EM emittierten Lichtbündels werden von FAC kollimatiert und treten in PSMG ein, die Form wie BM-IN, infolge der gegenseitigen Verschiebung der Kante jedes kleinen Prismas, die austretenden Lichtbündel sind BM-OUT. Fig. 13(a) und (c) sind zwei Sichtbilder der Lichtbündelzerlegung und der Lichtbündelverschiebung durch Keilensatz WG2, der aus verschiedenen großen und kleinen Keilen besteht. Fig. 13(b)(d) sind zwei Sichtbilder der Lichtbündelzerlegung und der Lichtbündelverschiebung durch Keilensatz WG3, der aus verschiedenen großen und kleinen Keilen besteht. Fig. 13(e) ist ein Beispiel bei Benutzung eines ebenen Spiegelsatzes MG-TR als Zerlegung und Verschiebung der Lichtbündeln, lichtemitierter Körper steht senkrecht zu der Zeichnungsebene. Einfallsrichtung des Lichtbündels relativ zu der Spiegelfläche bildet einen Winkel, so entsteht eine Ablenkung, Fig. 13(f) ist ein seitliches Sichtbild von MG-TR.

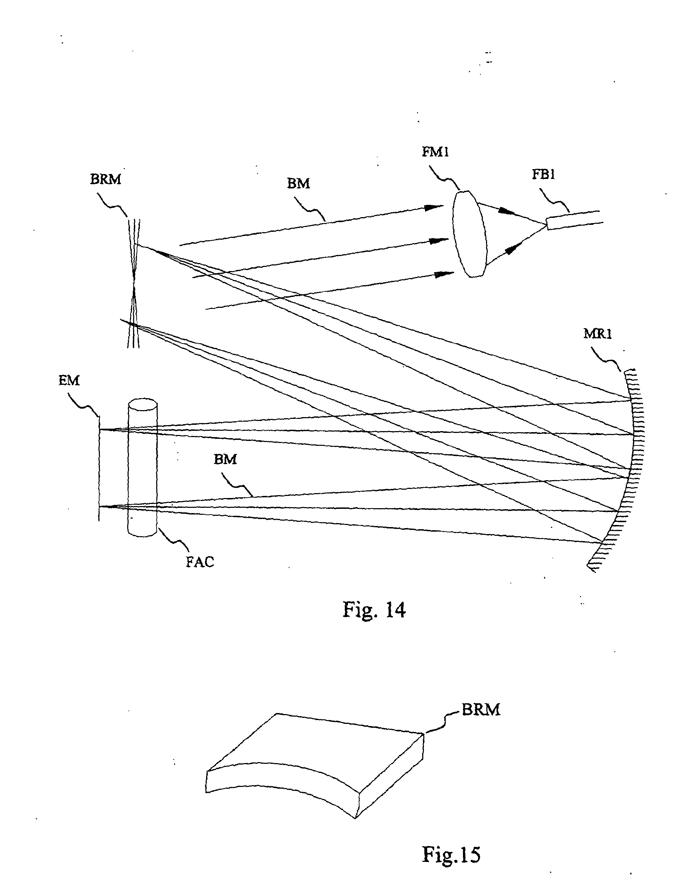

Über ein beliebiges optisches System gibt es oben schon einige Beispiele, Fig. 14 ist wieder ein Beispiel dazu. Hier ist AOS ein sphärisches Reflektionsspiegel MR1. Die vom lichtemitierten Körper EM von LDA stammenden Lichtbündel werden durch zylindrische optische Elemente FAC in der schnellen Achserichtung kollimatiert, infolge des Winkels zwischen FAC und EM entsteht Ablenkung der austretenden Lichtbündel, wie in Fig.3(e) gezeigt. Sphärischer Reflektionspiegel MR1 bildet diese schon abgelenkten Lichtbündels auf dem Lichtbündelrediktionator BRM (fokussiert oder defokussiert), MR1 kollimatiert gleichzeitig Lichtbündel in der langsamen Achserichtung. Lichtbündels nach Durchlauf von BRM werden neu ausgerichtet und nach einer Richtung (oder vorher festgelegten Richtungen) geführt und werden vom Fokussierungselemente FM1 ins Laser-aktive Medium FB1 oder andere lichttranspotierte Einrichtung eingeführt, FB1 ist optische Faser. Ganz klar ist dieses System bei Benutzung von MR1 sehr kompakt.

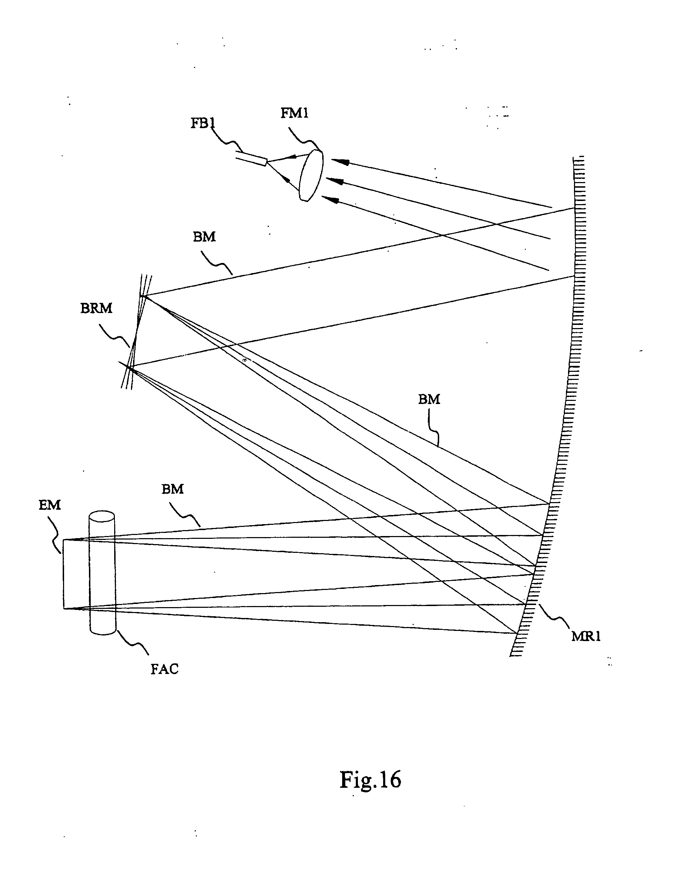

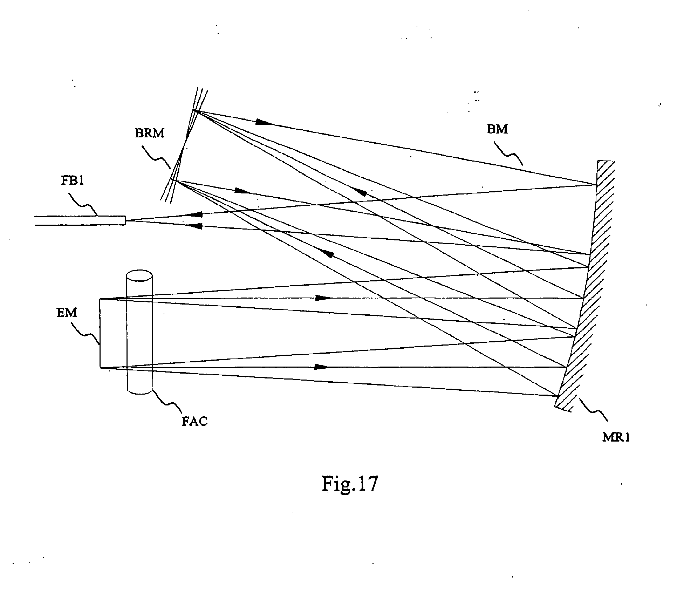

Bei Diskussion von Fig.2 ist schon Kombination des Lichtbündelablenkers BDM mit BR oder mit OS zu einem Element erwähntet, Fig. 15 zeigt ein kleiner Reflektionsspiegel zur Kombination zu einem Simulierenstück, das die Funktion von OS und BR hat. Beispiele Fig.16 und Fig.17 zeigen die Beweglichkeit der Lichtbündelumformmethode dieser Entdeckung. In Fig. 16 wird MR1 als OS benutzt, dieses System ist ähnlich der Fig. 14, aber zur Zeit wird MR1 gleichzeitig noch als ein teilweise Fokussierungssystem genutzt. Fig. 17 ist ähnlich der Fig. 16, aber jetzt wird MR1 gleichzeitig als OS und Fokussierungssystem genutzt.

Von der obigen Beschreibung kann man die Baustruktur des hocheffektiven Festkörperlasers erhalten: Enthalten ein Lasermedium, z. B. Laserfaser mit zweischichtigen Umhülle, Innenkern der Faser hat dortierte aktive Stoffe (benutzt in gepumpten Faserlaser) oder Laserstock (oder Platte) dortiert mit aktiven Stoffen; Fokusierungselemente und eine Lichtquelle. Lichtquelle enthält mindestens eine Halbleiterlaserarray; Lichtbündelablenker; Lichtbündelrediktionator und ein normales optisches System. Der beschriebene Lichtbündelablenker kollimatiert die vom lichtemitierten Körper von LDA stammenden Lichtbündel in der schnellen Achserichtung und entsteht eine Ablenkung. Das beschriebene normale optische System kollimatiert die schon abgelenkten Lichtbündel in langsamer Achsrichtung und lässt eintretende Lichtbündel auf dem Lichtbündelrediktionator fallen. Der beschriebene Lichtbündelrediktionator lässt austretende Lichtbündel nach einer Richtung oder nach einigen vorher festgelegten Richtungen laufen. Das beschriebene Fokussierungelement lässt die von der Lichtquelle emittierten Lichtbündel in den Lichtdurchlassloch des Mediums einführen. Dieses Medium kann dortiertes Glas oder Laserkristall sein.

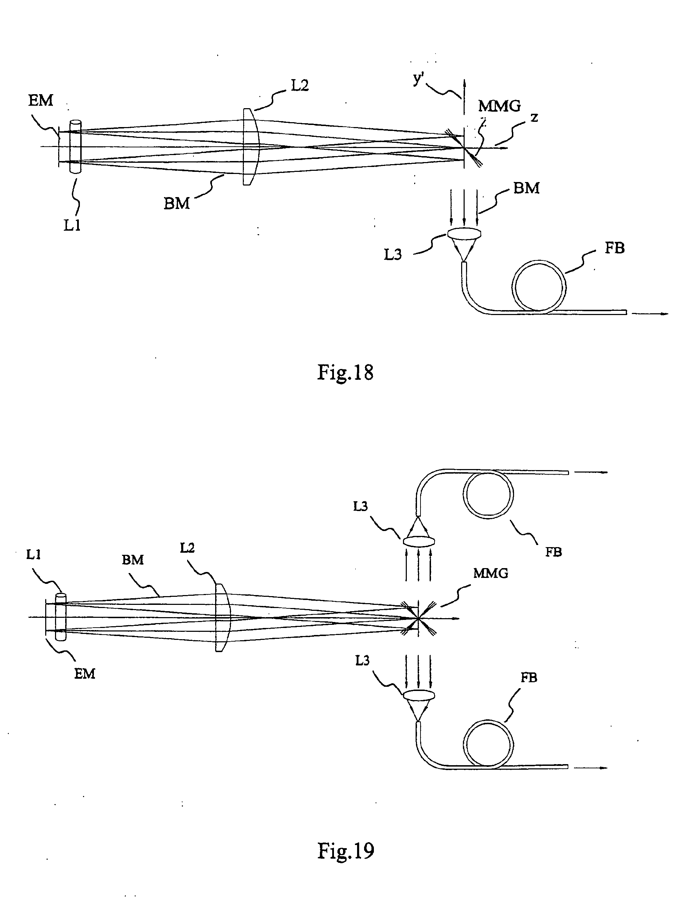

Fig.18 zeigt ein Beispiel vom optischen Faserlaser. Indem ist EM lichtemitierten Körper von LDA,BM ist Laserlichtbündel, Lichtbündelablenker L1, L1 ist auch eine Schnellachsekollimationslinse, Achse dieser Schnellachsekollimationslinse bildet mit EM einen kleinen Winkel. Die von L1 austretenden abgelenkten Lichtbündel laufen durch das normale optische System L2 und erreichen den ebenen Spiegelsatz MMG. MMG lässt die mit verschiedenem Einfallswinkel und schon abgelenkten Lichtbündels nach einer gleichen Richtung sich breiten. In diesem Beispiel, L2 kollimatiert Lichtbündel in der langsamen Achsrichtung und richten solche Lichtbündels längs der schnellen Achsrichtung aus und lässt diese Lichtbündel in MMG eintreten. Hinter MMG ist Bündelfleckform schon optimiert, Lagrange Konstant in der schnellen und langsamen Achserichtung ist ungefähr gleich. L3 ist Fokussierungslinse, welche die von MMG austretenden schon kollimatierten Lichtbündel in den Lichtdurchlassloch der Laserfaser FB fokussiert.

Im schon gezeigten Beispiel, Lichtbündelreditionator führt Lichtbündel nach einer Richtung oder einigen Richtungen, z. B. wenn eine Menge von kleinen Reflektionsspiegeln als Lichtbündelrediktionator benutzt wird, kleine Reflektionsspiegel können in einigen Gruppen aufgeteilt werden, jede Gruppe führt Lichtbündel in einer Richtung. Die von jeder Gruppe austretenden Lichtbündel können in eine optische Faser einfokussiert werden. Fig. 19 ist ein Beispiel mit zwei Ausgangslichtbündel. Dieses Beispiel ist ähnlich dem in Fig. 18 gezeigten Beispiel, aber hier besteht Lichtbündelrediktionator aus zwei Gruppen von Reflektionspiegeln, jede Gruppe von Reflektionsspiegeln reflektiert die Einfallslichtbündel fast zu einer gleichen Richtung, so kommen zwei Lichtbündel aus, welche in zwei optische Faser eingeführt werden können. Diese zwei Lichtbündel können z. B. benutzt werden, um die beiden Ende des Festkörperlasers zu pumpen.

Diese oben beschriebenen Methode und Einrichtungen können bei Transport der Lichtleistung der Halbleiterlaserarray in optischen Fasern genutzt werden. Weil die oben beschriebene Methode die Leistung mehrerer Halbleiterlaserarry effektiv in Laserfaser einführen können, deshalb kann die Hochlichtleistung durch optische Faser transportiert werden. So kann diese Lichtbündel mit Hochleistung in Laserlichtbearbeitung und Laserlichtheilung benutzt werden.

So nach dieser Entdeckung, eine mit optischen Fasern gekoppelte Halbleiterlaserarray enthält: mindestens eine optische Faser, mindestens ein Fokussierungselement und eine Lichtquelle. Die Lichtquelle enthält mindestens eine Halbleiterlaserarray, Lichtbündelablenker, ein bildabbildendes optisches System und Lichtbündelrediktionator. Der hier beschriebene Lichtbündelablenker kollimatiert die von der Halbleiterlaserarray austretenden Lichtbündel in der schnellen Achsrichtung,und lenkt Lichtbündels längst der Achserichtung gegenseitig ab.Das beschriebene optische System kollimatiert jedes schon abgelenkten Lichtbündels in der langsamer Achserichtung und lässt diese Lichtbündel in den beschriebenen Lichtbündelrediktionator eintreten, nachdem der Lichtbündelrediktionator breiten Lichtbündel sich nach einer vorher festgelegten Richtung, das beschriebene Fokussierungselement fokussiert die vom Lichtbündelrediktionator austretenden Lichtbündel in den Lichtdurchlassloch der optischen Faser.

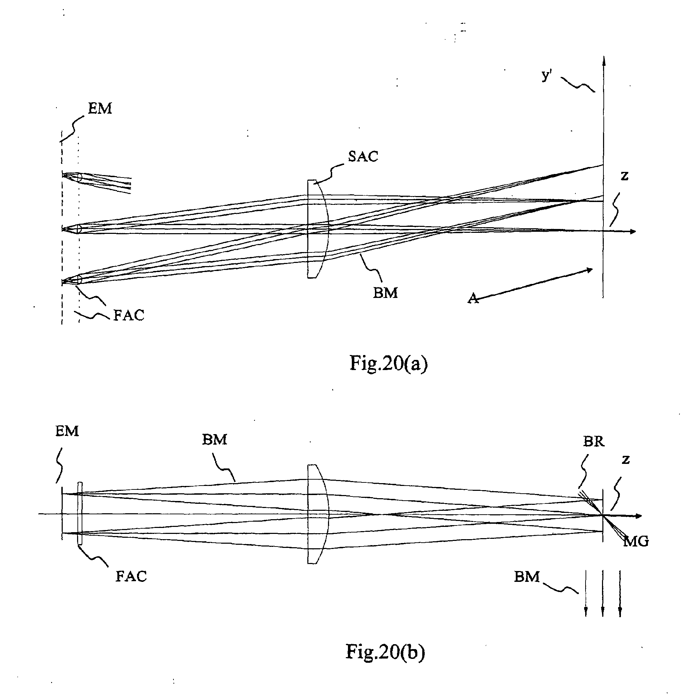

Mit obigen Beispielen dieser Entdeckung hat man nur das Ziel, diese Entdeckung zu erläutern, und man gibt keine Einschränkung der konkreten Formen dieser Entdeckung .Sehr klar mit der obigen Erläuterung kann man viele verschiedene Veränderungsformen fertigen. Zum Beispiel vor dem Lichtbündelablenker stellt man ein optisches System, um den Abstand zwischen zwei lichtemiterten Einheiten von LDA zu ändern, bei Benutzung von polarisierten Elementen oder bildumdrehendes System können Lichtbündels von LDA zu einem Lichtbündel zusammengestellt werden. Benutzung von Beugungselementen und Plastikoptikelementen. Benutzung der oben beschriebenen Methode kann man auch Lichtbündels der zweidimensionalen lichtemitierten Array umformt werden, Fig.20 zeigt ein Beispiel, in dem mehrere FAC werden als der lichtemitierten Körper (mit mehreren Streifen) der zweidimensionalen lichtemitierten Einheiten benutzt, Wirkungsweise ist oder wie frühere gleich.

## Patentansprüche

1. Eine optische Kopplungsmethode, die bei Umformen und Ausrichten der Lichtstralbündel benutzt, ihre besondere Merkmale bestehen in der konkreten Fertigungsmethode:
- Zuerst wählt man eine Halbleiterlaserarray, welche Lichtbündels in der schnellen und langsamen Achsrichtungen emittieren kann, als Lichtquelle;
- die oben beschriebenen von der Lichtquelle emittierten Lichtbündel werden in der schnellen Achsrichtung kollimatiert und abgelenkt;
- die oben in der schnellen Achsrichtung schon kollimatierten und abgelenkten Lichtbündel werden in der langsamen Achsrichtung kollimatiert und fallen dann ins nächste optische Element ein;
- nach der neuen Ausrichtung der oben beschriebenen Lichtbündel lässt man solche Lichtbündel nach einer Richtung oder mehreren vorher festgelegten Richtungen laufen.

2. Eine optische Kopplungseinrichtung zum Lichtbündelumformen und Lichtbündelneuausrichten enthält: eine Lichtquelle, die mindestens eine Halbleiterlaserarray hat, Lichtbündelablenker, Lichtbündelrediktionator und ein normales optisches System, das sich zwischen dem Lichtbündelablenker und dem Lichtbündelrediktionator befindet; der beschriebene Lichtbündelablenker kollimatiert die von den lichtemitierten Einheiten der Halbleiterlaserarray der beschriebenen Lichtquelle in der schnellen Achsrichtung und lenkt diese Lichtbündel längs der schnellen Achsrichtung mit verschiedenem Winkel abgelenkt; das beschriebene normale optische System kollimatiert die vom Lichtbündelablenker austretenden Lichtbündel in der langsamen Achsrichtung und lässt jedes Lichtbündel auf dem Lichtbündelrediktionator fallen und lässt Lichtbündel nach den Lichtbündelrediktionator in einer Richtung oder in mehreren vorher schon festgelegten Richtungen laufen.

3. Optische Kopplungseinrichtung nach Anspruch 2, **dadurch gekennzeichnet, dass** der Lichtbündelablenker ein zylindrisches optisches Element ist, dessen Zylinderachse mit dem lichtemitierten Körper der Halbleiterlaserarray einen vorher festgelegten Winkel bildet, oder ein stockförmiges Element ist, dessen Achse mit dem lichtemitierten Köper der Halbleiterlaserarray einen vorher festgelegten Winkel bildet, oder enthält einen Kollimator und einen gedrehten und gekrümmten Spiegel zur Ablenkung, oder enthält einen Kollimator und ein deformiertes Prisma, oder enthält eine mehrfachknotige Kollimationszylinderlinse.

4. Optische Kopplungseinrichtung nach Anspruch 2, **dadurch gekennzeichnet, dass** das beschriebene normale optische System ein optisches Brechungssystem oder ein optisches Reflektionssystem oder optisches Brechungs- und Reflektionssystem ist.

5. Optische Kopplungseinrichtung nach Anspruch 2, **dadurch gekennzeichnet, dass** der Lichtbündelrediktionator ein Satz von ebenen Spiegeln, oder ein Satz von optischen Keilen ist.

6. Optische Kopplungseinrichtung nach Anspruch 2, **dadurch gekennzeichnet, dass** die Einrichtung ein oder auch mindestens ein Fokussierungselement enthält.

7. Eine Lichtbündelumformeneinrichtung der Halbleiterlaserarray enthält mindestens eine Halbleiterlaserarray; Lichtbündelablenker; Lichtbündelrediktionator; ein normales optisches System, das sich zwischen dem beschriebenen Lichtbündelablenker und dem beschriebenen Lichtbündelrediktionators befindet; beschriebener Lichtbündelablenker kollimatiert die von lichtemitierten Einheiten stammenden Lichtbündel in der schnellen Achsrichtung, und lenkt Lichtbündel in der schnellen Achsrichtung gegenseitig parallel ab; das beschriebene optische System kollimatiert die vom Lichtbündelablenker austretenden Lichtbündel in der langsamen Achsrichtung und lässt Lichtbündel in den Lichtbündelrediktionator einfallen und lässt Lichtbündel nach der Durchlauf vom Lichtbündelrediktionator in einer Richtung oder in mehreren vorher schon festgelegten Richtungen sich breiten.

8. Lichtbündelumformeneinrichtung nach Anspruch 7, **dadurch gekennzeichnet, dass** der Lichtbündelablenker einen Satz des ebenen Spiegels, oder einen Satz von Prismen enthält.

9. Ein mit Halbleiterlaser gepumpten Festkörperlaser bei Benutzung der optischen Kopplungseinrichtung enthält ein Lasermedium, mindestens ein Fokussierungselement, eine Kopplungseinrichtung als Lichtquelle, beschriebene optische Kopplungseinrichtung enthält mindestens eine Halbleiterlaserarray, Lichtbündelablenker, welcher die von den lichtemitierten Einheiten der Halbleiterlaserarray stammenden Lichtbündel in der schnellen Achsrichtung kollimatiert und ablenkt, Lichtbündelrediktionator und ein optisches System, das sich zwischen dem Lichtbündelablenker und dem Lichtbündelrediktionator befindet und die vom Lichtbündelablenker austretenden Lichtbündel in der langsamen Achsrichtung kollimatiert und solche Lichtbündel auf den Lichtbündelrediktionator führt, Lichtbündelrediktionator lässt oben beschriebene Lichtbündel in einer vorher festgelegten Richtung breiten; das beschriebene Fokussierungselement steht zwischen der beschriebenen Lichtquelle und dem Lasermedium, Fokussierungselement führt die von Lichtquelle emitierten Lichtbündel in den Lichtdurchlassloch des Lasermediums ein.

10. Festkörperlaser nach Anspruch 9, **dadurch gekennzeichnet, dass** das Lasermedium Laserfaser oder Laserkristall oder Laserglas ist, wobei dessen Innerkern mit Laseraktivstoffen dortiert ist.

11. Eine mit optischer Faser gekoppelte Halbleiterlaserarray enthält mindestens eine optische Faser, Fokussierungselement, mindestens eine Lichtquelle, diese Lichtquelle enthält mindestens eine Halbleiterlaserarray, Lichtbündelablenker, abbildendes optisches System und Lichtbündelrediktionator; der beschriebene Lichtbündelablenker kollimatiert die von Halbleiterlaserarray austretenden Lichtbündel in der schnellen Achsrichtung und lenkt diese Lichtbündel längs der schnellen Achsrichtung ab; das beschriebene optische Abbildungssystem kollimatiert die oben beschriebenen Lichtbündel in der langsamen Achsrichtung und führt solche Lichtbündel in den Lichtbündelrediktionator ein, Lichtbündel nach der Durchlauf vom Rediktionator breiten nach mindestens einer vorher festgelegten Richtung; das beschriebene Fokussierungselement fokussiert die vom Lichtbündelrediktionator austretenden Lichtbündel in den Lichtdurchlassloch der beschriebenen optischen Faser.
